# EUROPÄISCHE PATENTANMELDUNG

(11) **EP 2 256 868 A1**
(43) Veröffentlichungstag der Anmeldung: **01.12.2010**
(21) Anmeldenummer: 09161207.7
(22) Anmeldetag: 27.05.2009
(51) Int. Cl.: H01R 9/26

(54) **Automatisierungsgerät mit einem Terminalmodul**

(71) Anmelder: SIEMENS AKTIENGESELLSCHAFT, 80333 München (DE)
(72) Erfinder: Bräunlich, Michael, 09117, Chemnitz (DE); Chowaniec, Michael, 09126, Chemnitz (DE); Dausend, Stefan, 91126, Schwabach (DE)

(57) **Zusammenfassung**

Die Erfindung betrifft ein Automatisierungsgerät (100) mit einem Terminalmodul (3), wobei in dem Terminalmodul (3) ein Funktionsmodul (4) gesteckt ist, geeignet zur modularen Erweiterung durch Aneinanderreihung weiterer Terminalmodule (3a, 3b), wobei das Terminalmodul (3) umfasst,
- ein erstes Aufnahmemittel (1) zur Aufnahme des Funktionsmoduls (4),
- ein ein erstes Kontaktmittel (11) aufweisendes zweites Aufnahmemittel (2) zur Aufnahme eines ein ein zweites Kontaktmittel (12) aufweisendes Anschlussmoduls (5), wobei über das Anschlussmodul (5) eine Versorgungsspannung für das Funktionsmodul (4) leitbar ist,

wobei ein Mittel (10) zur Überwachung der Versorgungsspannung in dem Funktionsmodul (4) integriert ist.

## Beschreibung

Die Erfindung betrifft ein Automatisierungsgerät mit einem Terminalmodul, wobei in dem Terminalmodul ein Funktionsmodul gesteckt ist, geeignet zur modularen Erweiterung durch Aneinanderreihung weiterer Terminalmodule, wobei das Terminalmodul umfasst, ein erstes Aufnahmemittel zur Aufnahme des Funktionsmoduls, ein ein erstes Kontaktmittel aufweisendes zweites Aufnahmemittel zur Aufnahme eines ein ein zweites Kontaktmittel aufweisenden Anschlussmoduls, wobei über das Anschlussmodul eine Versorgungsspannung für das Funktionsmodul leitbar ist.

Aus der EP 1 764 873 A1 ist ein solches modular aufbaubares Automatisierungsgerät bekannt, wobei das Terminalmodul mit einem Funktionsmodul kontaktierbar ist und wobei das Terminalmodul mit einem benachbarten Terminalmodul verbindbar ist.

Auch aus der DE 198 07 710 C2 ist ein derartiges Automatisierungsgerät mit einem Terminalmodul, Funktionsmodulen und einem Anschlussmodul, wobei eine Versorgungsspannung nicht über das Anschlussmodul geführt wird, bekannt.

Bei den genannten Automatisierungsgeräten, welche vorzugsweise zur Steuerung von industriellen Prozessen mit Einsatz einer sogenannten dezentralen Peripherie genutzt werden, wird eine Versorgungsspannung für die einzelnen Terminalmodule, in denen wiederum Funktionsmodule gesteckt sind, mittels Einspeisemodulen realisiert. Unter einem Funktionsmodul ist im Sinne der Erfindung, beispielsweise eine Ein-/Ausgabebaugruppe zur Anschaltung von Ein-/Ausgangssignalen aus dem industriellen Prozess, zu verstehen. Die Einspeisemodule nach dem Stand der Technik werden in einen freien Steckplatz von einem Terminalmodul gesteckt und versorgen so dann eine Gruppe von an das Einspeisemodul angeschlossenen weiteren Terminalmodulen, die wiederum weitere Funktionsmodule enthalten. Nach dem Stand der Technik werden durch Aneinanderreihen der entsprechenden Terminalmodule die Lastgruppen gebildet, innerhalb einer Lastgruppe werden alle Module vom gleichen Netzgerät gespeist. Bei dem Automatisierungsgerät nach DE 198 07 710 C2, siehe Absatz 20, wird durch die Terminalmodule die Versorgungsspannung von Terminalmodul zu Terminalmodul hindurchgeschleift.

Nachteilig hierbei ist, dass die Einspeisemodule jeweils einen eigenen Steckplatz belegen, und Änderungen einer Versorgungsspannungsgruppe oder auch Lastgruppe genannt, die Auftrennung einer solchen Gruppe nach sich zieht. Des Weiteren nachteilig ist, dass dieser Steckplatz für eigentliche Automatisierungsaufgaben, welche durch die Funktionsmodule gelöst werden sollen, verloren geht. Bisher waren in der Automatisierungstechnik für den modularen Aufbau solcher Geräte unterschiedliche Varianten bekannt, wie ein Kanal- oder Technologiemodul mit einer Versorgungsspannung zu versorgen ist. Bei diesen Lösungen ist es jedoch immer notwendig, dass ein "freier" Steckplatz für ein Einspeisemodul geopfert werden muss.

Es ist daher die Aufgabe der Erfindung, ein Automatisierungsgerät bereitzustellen, welche eine geringere bauliche Ausdehnung und damit einen geringeren Flächenbedarf einnimmt.

Die Aufgabe wird dadurch gelöst, dass bei dem eingangs genannten Automatisierungsgerät ein Mittel zur Überwachung der Versorgungsspannung in dem Funktionsmodul integriert ist. Damit kann vorteilhaft auf die Einspeisemodule verzichtet werden. Nach dem Stand der Technik wurde zuvor die Überwachung der Versorgungsspannung innerhalb der Einspeisemodule realisiert. Durch diese Verlagerung der Überwachung der Versorgungsspannung in die Funktionsmodule ist es möglich geworden, den Steckplatz eines Terminalmoduls weiterhin für ein Funktionsmodul zu nutzen.

Eine vorteilhafte Weiterbildung des Automatisierungsgerätes sieht vor, dass das erste Kontaktmittel einen ersten Anschluss, einen zweiten Anschluss, einen dritten Anschluss und einen vierten Anschluss aufweist, welche derart an einer ersten Seite und an einer zweiten Seite des Terminalmoduls angeordnet sind, das ein weiteres Terminalmodul mit seinem weiteren ersten Kontaktmittel an das erste Kontaktmittel anschließbar ist. Stellt man sich das Terminalmodul als Bausteinkomponente mit einer linken Seite, also einer ersten Seite und einer rechten Seite, also einer zweiten Seite, und einer dritten Seite zum Aufschnappen auf einen Baugruppenträger, beispielsweise einer Profilschiene, vor, so kann sich jeweils die erste Seite eines Terminalmoduls an die zweite Seite eines Vorgängerterminalmoduls anschmiegen und zu innerhalb der Terminalmodule angeordneten ersten Kontaktmitteln eine Verbindung aufnehmen. Weiterhin kann sich ein wiederum weiteres Terminalmodul mit seiner ersten Seite an die zweite Seite des Vorgängermoduls anlehnen und somit ein prinzipiell beliebig langer modularer Aufbau des Automatisierungsgerätes entstehen.

Von besonderem Vorteil ist es dabei, dass das Kontaktmittel derart ausgestaltet ist, dass eine Zusammenstellung einer ersten Gruppe, welche zumindest ein Terminalmodul umfasst, an eine erste Versorgungsspannung geschaltet ist. Der Begriff "Gruppe" ist im Sinne der beschriebenen Vorrichtung so zu verstehen, dass diese Gruppe nicht notwendigerweise drei Elemente aufweisen muss, welche üblicherweise eine Gruppe bilden, sondern die Gruppe im Sinne der Erfindung kann auch aus einem Terminalmodul mit einem Funktionsmodul oder aus einem Paar bestehen. In einer mechanischen Sichtweise beim Zusammenstecken der Terminalmodule kann man von einer Obergruppe sprechen, d.h. alle benötigten Terminalmodule in dem Automatisierungsgerät sind vorzugsweise bereits mechanisch miteinander verbunden, was beispielsweise durch entsprechende Verrastvorrichtungen an den Terminalmodulen ausgeführt sein kann. Das erste Kontaktmittel in jedem Terminalmodul ist dabei dazu ausgestaltet, dass durch Aufstecken eines entsprechenden Anschlussmoduls mit einem zweiten Kontaktmittel eine erste Gruppe von Terminalmodulen entsteht, welche im Hinblick auf eine gemeinsame Versorgungsspannung zusammengehören. Dies wird mit Vorzug dadurch erreicht, dass der erste Anschluss mit dem dritten Anschluss und der zweite Anschluss mit dem vierten Anschluss zum Weiterleiten der Versorgungsspannung innerhalb einer Gruppe miteinander über im Anschlussmodul angeordnete Brücken verbindbar sind.

Um einen Startpunkt für die erste Gruppe festzulegen, ist in einer weitführenden Ausgestaltung der dritte Anschluss und der vierte Anschluss jeweils mit einer im Anschlussmodul angeordneten ersten Versorgungsspannungsklemme und einer zweiten Versorgungsspannungsklemme zur Anschaltung einer Versorgungsspannung verbindbar. Ein nächster Streitpunkt einer zweiten Gruppe bildet dann ein weiteres Anschlussmodul mit Versorgungsspannungsklemmen und einem entsprechend ausgestaltetem ersten Kontaktmittel.

Ein derartiges Anschlussmodul, welches vorzugsweise als separater Klemmblock auf das Terminalmodul aufsteckbar ist weist dabei zumindest eine Klemmvorrichtung zum Anklemmen von weiteren Signalleitungen auf. Diese Klemmvorrichtung kann von der Art einer Schraubklemmvorrichtung, einer Schneidklemmvorrichtung oder einer Federklemmvorrichtung sein. Bei einer ersten Art eines Anschlussmoduls ist demnach neben den Klemmen für die Versorgungsspannung auch eine Klemmvorrichtung für Signalleitungen angeordnet. Bei einer zweiten Art des Anschlussmoduls entfallen die Anschlussklemmen für die Versorgungsspannung und es wird somit vorteilhaft Platz geschaffen für zusätzliche Anschlussklemmen, an die weitere Signalleitungen angeschlossen werden können. Da, wie bereits erwähnt, nach der zuvor geschilderten Ausgestaltung die Einspeisemodule entfallen können, wird mit Vorteil eine Freilaufdiode zur Funkenlöschung im Anschlussmodul angeordnet. Weiterhin ist es dabei vorteilhaft, dass neben der Freilaufdiode eine hochohmige Masseanbindung zur Realisierung eines potentialfreien Aufbaus eines Funktionsmoduls angeordnet ist. Die Freilaufdiode und die Masseanbindung sind dabei nur bei Anschlussmodulen, welche als Einspeisemodule ausgestaltet sind, aktiv geschaltet.

Potenzialfreier Aufbau heißt, dass die Masse der 24V-Versorgungsspannung nicht zwangsläufig niederohmig mit Erde verbunden ist, sonst würden bei mehreren Lastgruppen die 24V auf einer gemeinsamen Masse arbeiten, was vielfach technisch nicht erwünscht ist.

Eine nicht vorhandene niederohmige Verbindung zur Erde kann dazu führen, dass sich zwischen dem 24 V - Potenzial des Netzgerätes (24V und Masse) und der Erde eine Potenzialdifferenz ausbildet, die durchaus weit über 100V betragen kann. Dies geschieht vorrangig dadurch, dass in die (24V-)Zuleitungen über in der Umgebung befindliche elektromagnetische Felder Energie induziert wird, welches zu einer Spannungs-Anhebung sowohl der Masseleitung, als auch der 24V-Leitung zu Erde führt. Dies wäre technisch eine Gleichtakt-Störung, da die beiden Leitungen (24V und Masse) parallel in einem Kabel verlegt werden und gleichermaßen von der Potenzialanhebung betroffen sind. Würden sie getrennt in einzelnen Leitungen verlegt, was praktisch in der Regel ausgeschlossen werden kann, könnte es auch zu getrennten Potenzialveränderungen in beiden Leitungen und damit zu einer Erhöhung der Spannungsdifferenz von nominell 24V auf wesentlich höhere Werte kommen (Gegentakt-Störung) hier greift die Schutzschaltung im Anschlussmodul und die zu hohe Spannung wird abgeschaltet. Da die Energieeinspeisung über elektromagnetische Felder relativ hochohmig ist, genügt eine hochohmige Anbindung an die Erde, um diese Energien abzuleiten.

Um einen Inbetriebnehmer bzw. einem Monteur für eine Automatisierungsanlage eine Konfiguration des Automatisierungsgerätes in unterschiedliche Gruppen zu erleichtern, ist das Anschlussmodul ausgestaltet um die Erkennbarkeit von Gruppenzusammenstellung bei der Draufsicht auf das Gerät zu erleichtern, es ist vorzugsweise eine erste optische Ausprägung für ein Anschlussmodul mit einer Einspeisefunktion für die Versorgungsspannung und eine zweite optische Ausprägung für ein Anschlussmodul mit einer Weiterleitungsfunktion der Versorgungsspannung realisiert. Eine Erkennbarkeit der einzelnen Gruppen bzw. die damit entstehenden Lastgruppen ist dadurch leichter. Vorstellbar wären z.B. ein schwarzer Kunststoffblock für die Einspeisung einer Versorgungsspannung und ein weißer Kunststoffblock für die Weiterleitung der Versorgungsspannung. Des Weiteren ist das Anschlussmodul als eine bauliche Einheit ausgeprägt wie sie z.B. ein Klemmblock darstellt. Dieser Klemmblock weist dazu eine Einheit aus Klemmen, eine Leiterplatte für Freilaufdiode, Funkenlöschung, Potentialtrennung und einen Peripherieverbinder zur Verbindung des Klemmblockes mit dem Terminalmodul auf.

Dank der Erfindung ist es nun möglich, bei einer nachträglichen Änderung des modularen Aufbaus hinsichtlich der Gruppen einen Klemmblock, also das Anschlussmodul ohne Auseinanderrücken der Terminalmodule zu wechseln, so dass eine neue Gruppenbildung entsteht. Die nachträgliche Änderung der Lastgruppen wird nun nicht mehr durch den Austausch eines kompletten Terminalmoduls erschwert.

Die Zeichnungen zeigen ein Ausführungsbeispiel des erfindungsgemäßen Automatisierungsgerätes, dabei ist in
- FIG 1: ein Terminalmodul dargestellt,
- FIG 2: ein Anschlussmodul zum Weiterleiten der Versorgungs- spannung,
- FIG 3: ein Anschlussmodul zum Einspeisen der Versorgungs- spannung und
- FIG 4: ein modular aufgebautes Automatisierungssystem mit drei Lastgruppen.

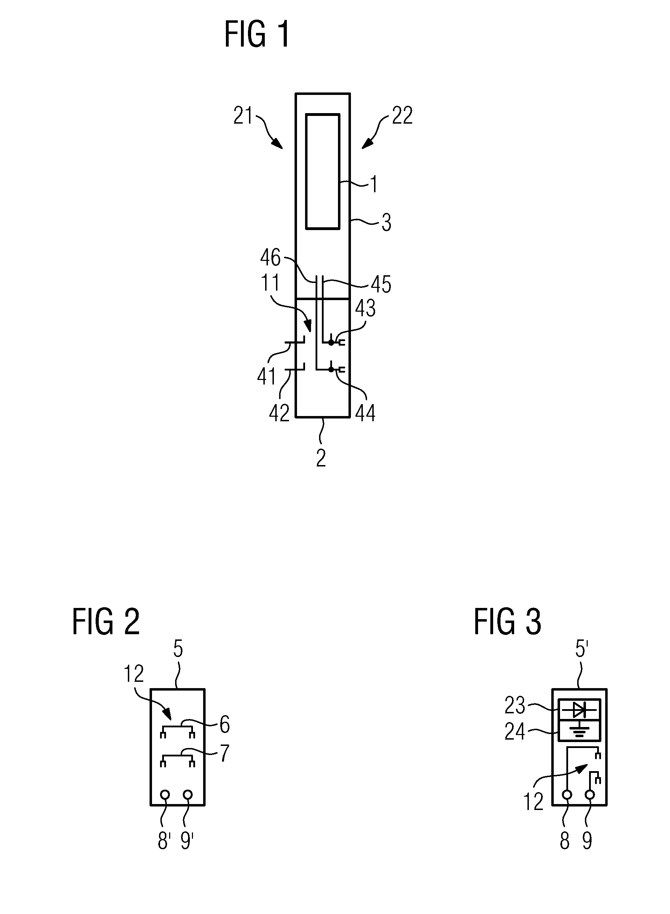

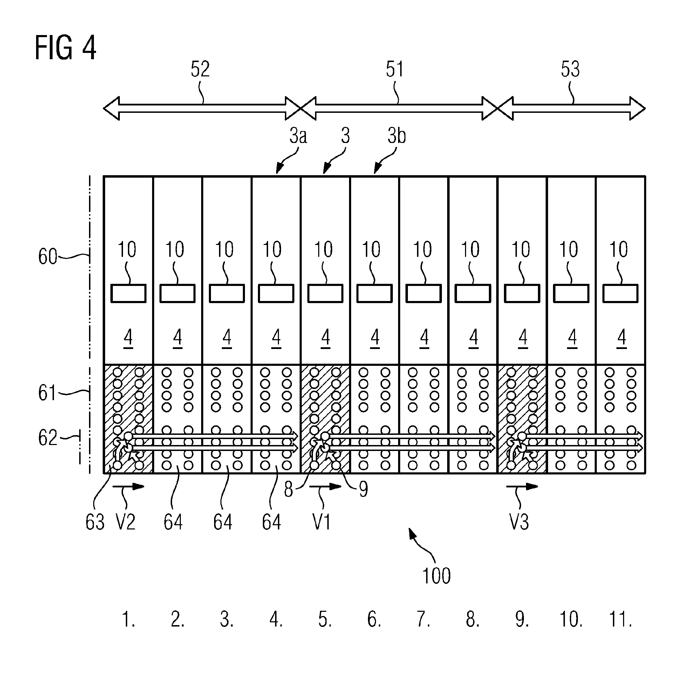

Gemäß FIG 1 ist ein Terminalmodul 3 für ein Automatisierungsgerät 100 (FIG 4) zum modularen Aufbau des Automatisierungsgerätes 100 dargestellt.

Das Terminalmodul 3 umfasst ein erstes Aufnahmemittel 1 zur Aufnahme eines Funktionsmoduls 4 (FIG 4), ein zweites Aufnahmemittel 2 zur Aufnahme eines ersten Anschlussmoduls 5 (FIG 2) oder eines zweiten Anschlussmoduls 5' (FIG 3). Das erste Aufnahmemittel 1 und das zweite Aufnahmemittel 2 sind schachtartig ausgestaltet, so dass ein Funktionsmodul 4 bzw. ein Anschlussmodul 5, 5' mit steckerartig ausgeprägten Kontaktelementen in die jeweiligen Schächte zur mechanischen Befestigung und elektrischen Kontaktierung gesteckt werden können. Das Terminalmodul 3 weist eine erste Seite 21 und eine zweite Seite 22 auf. Dabei ist das Terminalmodul 3 als eine quaderförmige Komponente mit sechs Seitenflächen ausgestaltet. Die erste Fläche der ersten Seite 21 kann sich beispielsweise an eine Kopfbaugruppe des Automatisierungsgerätes 100 anlehnen und somit einen Startpunkt zum modularen Aufbau des Automatisierungsgerätes 100 bilden, wobei an die zweite Seite 22 des Terminalmoduls 3 ein weiteres Terminalmodul mit seiner weiteren ersten Seite 21 angelegt wird, wobei über die Terminalmodule über jeweils ein erstes Kontaktmittel 11 in Verbindung stehen.

Das erste Kontaktmittel 11 weist einen ersten Anschluss 41, einen zweiten Anschluss 42, einen dritten Anschluss 43 und einen vierten Anschluss 44 auf. Der erste Anschluss 41 und der zweite Anschluss 42 sind derart in dem Terminalmodul angeordnet, dass zur Kontaktierung eines anderen Terminalmoduls jeweils ein erstes Ende des ersten Anschlusses 41 und des zweiten Anschlusses 42 aus dem quaderförmigen Gehäuse des Terminalmoduls 3 hinausragen. Ein jeweils zweites Ende des ersten Anschlusses 41 und des zweiten Anschlusses 42 sind derart mit Kontaktelementen innerhalb des Terminalmoduls 3 bzw. innerhalb des zweiten Aufnahmemittels 2 angeordnet, so dass sich Kontaktmittel, beispielsweise Brücke oder Einspeiseklemmen, auf die zweiten Enden aufstecken lassen.

Der dritte Anschluss 43 und der vierte Anschluss 44 sind derart ausgestaltet, dass sich jeweils ein erstes Ende der Anschlüsse 43, 44 so innerhalb des Gehäuses des Terminalmoduls 3 befindet, dass der erste Anschluss 41 und der zweite Anschluss 42 eines weiteren Terminalmoduls 3b mit seinen jeweils ersten Enden in die jeweils ersten Enden der dritten und vierten Anschlüsse des Vorgängerterminalmoduls 3 steckbar sind. An ein zweites Ende des dritten Anschlusses 43 ist eine erste Leitung 45 angeschlossen und an ein zweites Ende des Anschlusses 44 ist eine zweite Leitung 46 angeschlossen. Die erste und die zweite Leitung 45, 46 dienen zur Einleitung der Versorgungsspannung in das Terminalmodul 3 von dem zweiten Aufnahmemittel 2 in das erste Aufnahmemittel 1.

Ein in das erste Aufnahmemittel 1 gestecktes Funktionsmodul 4 wird über die erste Leitung 45 und die zweite Leitung 46 mit einer über das erste Kontaktmittel 11 angeschlossenen bzw. eingespeisten Versorgungsspannung versorgt. Dabei ist das erste Kontaktmittel 11 mit seinem dritten Anschluss 43 und seinem vierten Anschluss 44 ausgestaltet zur Aufnahme von Kontaktmitteln welche eine Weiterleitung der Versorgungsspannung über die Anschlussmodule 5 bzw. 5' ermöglichen.

Gemäß FIG 3 ist ein Anschlussmodul 5' zur Einspeisung einer Versorgungsspannung in das Terminalmodul 3 dargestellt. Das Anschlussmodul 5' weist ein zweites Kontaktmittel 12 auf. Das zweite Kontaktmittel 12 ist dabei mit einer ersten Versorgungsspannungsklemme 8 und einer zweiten Versorgungsspannungsklemme 9 ausgestaltet, wobei die Versorgungsspannungsklemmen 8, 9 mit Kontaktelementen in Verbindung stehen, welche im eingesteckten Zustand des Anschlussmoduls 5' in das zweite Aufnahmemittel 2 mit dem ersten Anschluss 43 und dem zweiten Anschluss 44 über entsprechend ausgelegte Kontaktelemente kontaktieren und so die Einleitung einer Versorgungsspannung über die Versorgungsspannungsklemmen 8, 9 über die erste Leitung 45 und die zweite Leitung 46 in das erste Aufnahmemittel 1 ermöglichen und somit bei einem eingesteckten Funktionsmodul 4 in das erste Aufnahmemittel 1 die Versorgung des Funktionsmoduls 4 mit einer Versorgungsspannung gewährleistet.

Im Anschlussmodul 5', welches als ein Einspeisemodul ausgestaltet ist, ist zur Funkenlöschung eine Freilaufdiode 23 angeordnet. Weiterhin ist für einen potentialfreien Aufbau, eine hochohmige Masseanbindung 24 innerhalb des Anschlussmoduls 5' angeordnet. Das Anschlussmodul 5' ist als eine bauliche Einheit ausgeprägt, wobei diese bauliche Einheit Klemmen zum Anklemmen von Signalleitungen und Versorgungsspannungsleitungen, eine Leiterplatte für die Freilaufdiode 23, die hochohmige Masseanbindung 24 und für eine Peripherieanbindung zur Verbindung des Anschlussmoduls 5' mit in den zweiten Aufnahmemittel 2 welches entsprechend angeordneten Gegenkontakte aufweist, umfasst.

Die Beschaltung in 5' ist dabei so ausgelegt, dass die Anschlüsse 41 und 42 des Terminalmoduls 2 nicht kontaktiert werden. Somit wird die am linken Nachbarmodul anliegende Lastspannung nicht weitergeleitet sondern unterbrochen, gleichzeitig wird die an die Klemmen 8 und 9 angeschlossene Lastspannung ebenfalls nicht nach links weitergeleitet und damit quasi eine neue Lastgruppe begonnen. Die neue Lastspannung liegt wiederum an den Kontakten 43 und 44 an und kann dort vom nächsten Terminalmodul bei Vorhandensein eines Elementes nach FIG 2 genutzt werden. Hat aber das rechte Nachbarterminalmodul ein Element nach FIG 3 montiert, würde dort erneut eine neue Lastgruppe beginnen.

Gemäß FIG 2 ist eine zweite Art eines Anschlussmoduls 5 dargestellt. Das Anschlussmodul 5 weist ein erstes Kontaktmittel 12 auf, wobei bei dieser Ausgestaltung das erste Kontaktmittel 12 eine erste Brücke 6 und eine zweite Brücke 7 umfasst. Dabei sind die Brücken 6, 7 derart ausgestaltet, dass sie bei einem Aufrasten des Anschlussmoduls 5 in oder auf das Aufnahmemittel 2, den ersten Anschluss 41 mit dem dritten Anschluss 43 und den zweiten Anschluss 42 mit dem vierten Anschluss 44 verbinden. Eine über ein Vorgängerterminalmodul eingespeiste Versorgungsspannung wird mittels der ersten Brücke 6 von dem ersten Anschluss 41 zu dem zweiten Anschluss 43 und mittels der zweiten Brücke 7 von dem zweiten Anschluss 42 zu dem vierten Anschluss 44 weitergeleitet. Die bei der ersten Art des Anschlussmoduls 5' nach FIG 3 benötigten Versorgungsspannungsklemmen 8, 9, hier als 8', 9' dargestellt, können nun anstelle der Einspeisung einer Versorgungsspannung für weitere Signalklemmen genutzt werden.

Gemäß FIG 4 ist ein modular aufgebautes Automatisierungsgerät 100 mit einer ersten Gruppe 51, einer zweiten Gruppe 52 und einer dritten Gruppe 53 dargestellt. Das Automatisierungsgerät 100 umfasst elf aneinander gereihte Terminalmodule. In jedes dieser elf aneinander gereihten Terminalmodule ist ein Funktionsmodul 4 gesteckt. Jedes Funktionsmodul 4 weist dabei ein Mittel 10 zur Überwachung der Versorgungsspannung V1, V2, V3 auf. Von links nach rechts betrachtet bilden die ersten vier Terminalmodule 3 mit ihren gesteckten Funktionsmodulen 4 eine zweite Gruppe 52. Das erste Terminalmodul 1, wird durch das gesteckte Anschlussmodul 5' mit Einspeisefunktionalität zu einen Startpunkt für die zweite Gruppe 52. Die über das Anschlussmodul 5' des ersten Terminalmoduls 1 eingespeiste Versorgungsspannung V2 wird über weitere Anschlussmodule mit Weiterleitungsfunktionalität bis zum vierten Terminalmodul bzw. bis zum vierten Funktionsmodul 4 weitergeleitet.

Ab dem fünften Terminalmodul 3 wird eine neue Gruppe, nämlich die erste Gruppe 51, durch ein in das fünfte Terminalmodul gestecktes Anschlussmodul mit Einspeisefunktionalität eröffnet. Über entsprechende Anschlussmodule mit Weiterleitungsfunktionalität wird die eingespeiste Versorgungsspannung V1 bis zu einem achten Terminalmodul weitergeleitet.

Mit dem neunten Terminalmodul wird wieder über ein entsprechend ausgestaltetes Anschlussmodul mit Einspeisefunktionalität eine dritte Versorgungsspannung V3 eingespeist, welche über das zehnte und elfte Terminalmodul mit Anschlussmodulen mit einer Weiterleitungsfunktionalität weitergeleitet wird. Die zweite Gruppe 52 besteht aus dem ersten bis vierten Terminalmodul. Die erste Gruppe 51 besteht aus dem fünften bis achten Terminalmodul und die dritte Gruppe 53 besteht aus dem neunten bis elften Terminalmodul.

Das Automatisierungsgerät 100 ist aufgeteilt in einen Modulbereich 60, einen Klemmbereich 61 und einen Versorgungsspannungsbereich 62. Den Versorgungsspannungsbereich 62 kann man auch als Powerbus oder durchgeschleifte Versorgungsspannungsleitungen bezeichnen. Die Anschlussmodule 5, 5' sind dabei mit ihrem Klemmbereich 61 so ausgestaltet, dass neben Einspeiseklemmen 8, 9 für Versorgungsspannungen V1, V2, V3 auch eine Mehrzahl von Klemmen zum Anklemmen von Signalleitungen für Signale aus dem industriellen Prozess angeordnet sind.

Für den Fall, dass ein Anschlussmodul 5' mit Einspeisefunktionalität verwendet wird, werden die unteren beiden Klemmen 8, 9 eines Anschlussmoduls zur Einspeisung einer Versorgungsspannung V1, V2, V3 genutzt.

Für den Fall eines Anschlussmoduls 5 mit Weiterleitungsfunktionalität werden die unteren beiden Einspeiseklemmen 8', 9' für die Einspeisung einer Versorgungsspannung nicht benötigt und können somit vorteilhafte für das Anklemmen von weiteren Signalleitungen genutzt werden.

Die Kombination von Terminalmodul 3 mit entsprechend ausgeprägten ersten Kontaktmittel 11, dem jeweilig in das zweite Aufnahmemittel 2 gestecktem Anschlussmodul 5, 5' und das gesteckte Funktionsmodul 4 mit innerhalb des Funktionsmoduls 4 angeordneten Mitteln 10 zur Überwachung der Versorgungsspannung ergeben eine Wechselwirkung, welche einen Synergieeffekt hervorbringt. Als Vorteile ergeben sich ein zusätzlich frei gewordener Steckplatz, da kein separates Einspeisemodul mehr gesteckt werden muss, ein unabhängiger Aufbau von Gruppen 51, 52, 53 in sogenannte Lastgruppen oder Gruppen mit unterschiedlichen Versorgungsspannungen, und ein erleichterter Umbau eines Automatisierungsgerätes 100, da nun nicht mehr zur Änderung der Lastgruppen die Terminalmodule auf einer Profilschiene verrückt werden müssen.

## Patentansprüche

1. Automatisierungsgerät (100) mit einem Terminalmodul (3), wobei in dem Terminalmodul (3) ein Funktionsmodul (4) gesteckt ist, geeignet zur modularen Erweiterung durch Aneinanderreihung weiterer Terminalmodule (3a, 3b), wobei das Terminalmodul (3) umfasst,
- ein erstes Aufnahmemittel (1) zur Aufnahme des Funktionsmoduls (4),
- ein ein erstes Kontaktmittel (11) aufweisendes zweites Aufnahmemittel (2) zur Aufnahme eines ein ein zweites Kontaktmittel (12) aufweisendes Anschlussmoduls (5), wobei über das Anschlussmodul (5) eine Versorgungsspannung für das Funktionsmodul (4) leitbar ist,
**dadurch gekennzeichnet**, das ein Mittel (10) zur Überwachung der Versorgungsspannung in dem Funktionsmodul (4) integriert ist.

2. Automatisierungsgerät (100) nach Anspruch 1, wobei das erste Kontaktmittel (11) einen ersten Anschluss (41), einen zweiten Anschluss (42), einen dritten Anschluss (43) und einen vierten Anschluss (44) aufweist, welche derart an einer ersten Seite (21) und an einer zweiten Seite (22) des Terminalmoduls (3) angeordnet sind, dass ein weiteres Terminalmodul (3a) mit seinem weiteren ersten Kontaktmittel an das erste Kontaktmittel (11) anschließbar ist.

3. Automatisierungsgerät (100) nach Anspruch 1 oder 2, wobei das erste Kontaktmittel (11) derart ausgestaltet ist, dass eine Zusammenstellung einer ersten Gruppe (51), welche zumindest ein Terminalmodul (3) umfasst, an eine erste Versorgungsspannung (V1) geschaltet ist.

4. Automatisierungsgerät (100) nach Anspruch 3, wobei der erste Anschluss (41) mit dem dritten Anschluss (43) und der zweite Anschluss (42) mit dem vierten Anschluss zum Weiterleiten der Versorgungsspannung innerhalb einer Gruppe miteinander über im Anschlussmodul (5) angeordnete Brücken (6,7) verbindbar sind.

5. Automatisierungsgerät (100) nach einem der Ansprüche 2 bis 4, wobei der dritte Anschluss (43) und der vierte Anschluss (44) jeweils mit einer im Anschlussmodul (5) angeordneten ersten Versorgungsspannungsklemme (8) und
einer zweiten Versorgungsspannungsklemme (9) zur Anschaltung einer Versorgungsspannung (V1) verbindbar sind.

6. Automatisierungsgerät (100) nach einem der Ansprüche 1 bis 5, wobei das Anschlussmodul (5) zumindest eine Klemmvorrichtung zum Anklemmen von weiteren Signalleitungen für das Funktionsmodul (4) der folgenden Art aufweist:
- eine Schraubklemmvorrichtung,
- eine Schneidklemmvorrichtung,
- eine Federklemmvorrichtung.

7. Automatisierungsgerät (100) nach einem der Ansprüche 1 bis 6, wobei im Anschlussmodul (5) eine Freilaufdiode (23) zur Funkenlöschung angeordnet ist.

8. Automatisierungsgerät (100) nach einem der Ansprüche 1 bis 7, wobei im Anschlussmodul (5) eine hochohmige Masseanbindung (24) zur Realisierung eines potentialfreien Aufbaus eines Funktionsmoduls (4) angeordnet ist.

9. Automatisierungsgerät (100) nach einem der Ansprüche 1 bis 8, wobei das Anschlussmodul (5)ausgestaltet ist, um die Erkennbarkeit von Gruppenzusammenstellungen bei der Draufsicht auf das Gerät zu erkennen, vorzugsweise eine erste optische Ausprägung für ein Anschlussmodul mit einer Einspeisungsfunktion für die Versorgungsspannung und eine zweite optische Ausprägung für ein Anschlussmodul mit einer Weiterleitungsfunktion der Versorgungsspannung.
